# EUROPEAN PATENT SPECIFICATION

(11) **EP 2 604 719 B1**
(45) Date of publication and mention of the grant of the patent: **11.11.2020**
(21) Application number: 11816328.6
(22) Date of filing: 02.08.2011
(51) Int. Cl.: C22C 27/02, C23C 14/34

(54) **TANTALUM SPATTERING TARGET**
TANTALUM-SPUTTERTARGET
CIBLE DE PULVÉRISATION DE TANTALE

(30) Priority: 09.08.2010 JP 2010178742
(43) Date of publication of application: 19.06.2013
(73) Proprietor: JX Nippon Mining & Metals Corporation, Tokyo 105-8417 (JP)
(72) Inventor: SENDA Shinichiro, Kitaibaraki-shi Ibaraki 319-1535 (JP); FUKUSHIMA Atsushi, Kitaibaraki-shi Ibaraki 319-1535 (JP)
(74) Representative: Liesegang, Eva
(86) International application number: PCT/JP2011/067651
(87) International publication number: WO 2012/020662

(56) References cited:
- WO-A1-2010/134417
- WO-A1-2011/018970
- WO-A1-2011/018971
- WO-A2-2006/001976
- JP-A- 2001 020 065
- JP-A- 2002 363 662
- JP-A- 2007 239 104
- US-A1- 2007 089 815
- US-A1- 2009 134 021
- US-B1- 6 589 311
- GOOD-SUN CHOI ET AL.: 'Preparation of 5N grade tantalum by electron beam melting' JOURNAL OF ALLOYS AND COMPOUNDS vol. 469, no. 1-2, 05 February 2009, pages 298 - 303

## Description

### TECHNICAL FIELD

The present invention relates to a high-purity tantalum sputtering target having a uniform and fine structure and enabling plasma stabilization and achievement of superior film evenness (uniformity).

### BACKGROUND ART

In recent years, the sputtering method for forming films from materials such as metal or ceramics has been used in numerous fields, which include the electronics field, the field of corrosion resistant materials and decoration, the catalytic field, as well as in the manufacture of cutting/polishing materials and abrasion-resistant materials.

While the sputtering method itself is a well-known method in the foregoing fields, particularly in the electronics field, a tantalum sputtering target suitable for forming films of complex shapes, forming circuits or forming barrier films is recently in demand.

Generally, this tantalum target is manufactured by repeating the hot forging and annealing (heat treatment) of an ingot or billet formed by performing electron beam melting and casting to a tantalum raw material, and thereafter performing rolling and finish processing (mechanical processing, polishing, etc.) thereto in order to process the ingot or billet into a target.

In this kind of production process, the hot forging performed to the ingot or billet will destroy the cast structure, disperse or eliminate the pores and segregations, and, by further performing annealing thereto, recrystallization will occur, and the densification and strength of the structure are improved.

The molten and cast ingot or billet generally has a crystal grain size of 50 mm or more. As a result of subjecting the ingot or billet to hot forging and recrystallization annealing, the cast structure is destroyed, and generally uniform and fine (100 µm or less) crystal grains can be obtained.

Meanwhile, if sputtering is to be performed using a target produced as described above, it is said that the recrystallized structure of the target becomes even finer and more uniform, more uniform deposition is possible with a target in which the crystal orientation is aligned toward a specific direction, and a film with low generation of arcing and particles and stable characteristics can be obtained.

Thus, measures are being taken, in the production process of the target, for achieving a finer and more uniform recrystallized structure and aligning the crystal orientation toward a specific direction (for example, refer to Patent Document 1 and Patent Document 2).

Moreover, disclosed is a high-purity Ta target for forming a TaN film to be used as a barrier layer against a Cu wiring film, obtained by using a high-purity Ta, in which an element having self-sustained discharge characteristics selected among Ag, Au and Cu is contained in an amount of 0.001 to 20 ppm, the total amount of Fe, Ni, Cr, Si, Al, Na, and K as impurity elements is 100 ppm or less, and the value after deduction of the content of these elements is within the range of 99.99 to 99.999% (refer to Patent Document 3).

When reviewing these Patent Documents, there is no disclosure to the effect that the inclusion of a specific element realizes a finer structure and thereby stabilizes the plasma.

In particular, Patent Document 3 describes that an element selected among Ag, Au and Cu is contained in an amount of 0.001 to 20 ppm, and the discharge amount of Ta ions increases by adding an infinitesimal amount, 0.001 ppm at minimum, of an element. However, since the additive element is contained in a trace amount, it is considered that there is a problem in that it is difficult to adjust the content and realize a uniform addition (spread).

In addition, as shown in Table 2 of Patent Document 3, the inclusion of Mo, W, Ge, and Co contents is respectively tolerated at less than 10 ppm, 20 ppm, 10 ppm, and 10 ppm. Accordingly, these impurities alone are contained in an amount less than 50 ppm.

Accordingly, as described above, Patent Document 3 describes that a high-purity Ta, in which the total amount of Fe, Ni, Cr, Si, Al, Na, and K as impurity elements is 100 ppm or less, and the value after deduction of the content of these elements is within the range of 99.99 to 99.999%, is used. However, the lower limit of the actual purity falls below (tolerates) 99.99%. This is a level that is lower than conventional high-purity tantalum, and it is strongly assumed that the characteristics of high-purity tantalum cannot be utilized.

US 6,589,311 B1 refers to a method for making high-melting metal powder, in particular to making metal powder having spherical particles made of Ta, Tu and other materials having higher melting points than iron. For this purpose, a sputtering target comprising sintered powder compact is provided, wherein the purity of the powder compact exceeds 99.999 % and the oxygen concentration of the powder compact is lower than 100 ppm. The document thus suggests making a Ta based sintered powder compact, which shows high density and a fine micro-structure.

WO 2006/001976 A2 refers to a method providing a metal or metal alloy having powder particles. The powder is pressure consolidated to form a blank having predefined density. In this way, W, Ta, Mo and Hf targets and alloys can be prepared.

US 2009/0134021 A1 refers to providing a tantalum or a tantalum alloy target adapted to shorten the burn-in time and minimizing the deposition speed throughout the target life. For this purpose, the document suggests that the full width of half maximum of a crystal plane measured by X-ray diffraction should be 0.1 to 0.6, in order to shorten the burn-in time and inhibit changes in deposition speed. Here, the respective full width of half maximum of a crystal plane can have variations caused by deformation processing such as forging and rolling.

A further tantalum sputtering target is described in US 2007/0 089 815 A1.

[Patent Document 1] Published Japanese Translation No. 2002-518593 of PCT Application
[Patent Document 2] US Patent No. 6,331,233
[Patent Document 3] Japanese Laid-Open Patent Publication No. 2002-60934

### SUMMARY OF INVENTION

### [Technical Problem]

An object of the present invention is to provide a high-purity tantalum sputtering target having a uniform and fine structure and enabling plasma stabilization and achievement of superior film evenness (uniformity) by maintaining the high purity of tantalum and adding a specific element.

### [Solution to Problem]

In order to achieve the foregoing object, the present inventors discovered that it is possible to obtain a high-purity tantalum sputtering target having a uniform and fine structure and enabling plasma stabilization and achievement of superior film evenness (uniformity) by maintaining the high purity of tantalum and adding a specific element.

Based on the foregoing discovery, the present invention provides a tantalum sputtering target according to claim 1, in particular:
1) A tantalum sputtering target, wherein 30 mass ppm or more and 100 mass ppm or less of oxygen is contained as an essential component, and the purity excluding oxygen and gas components is 99.998% or higher and wherein the average crystal grain size of the recrystallized structure is 120 µm or less;
2) A tantalum sputtering target, wherein 40 mass ppm or more and 100 mass ppm or less of oxygen is contained as an essential component, and the purity excluding oxygen and gas components 99.998% or higher;
3) A tantalum sputtering target, wherein 40 mass ppm or more and 70 mass ppm or less of oxygen is contained as an essential component, and the purity excluding oxygen and gas components is 99.998% or higher;
4) The tantalum sputtering target according to any one of 1) to 3) above, wherein variation in the oxygen content in the target is ±20% or less;
6) The tantalum sputtering target according to one of 1) to 4) above, wherein variation in the crystal grain size is ±20% or less.

### EFFECTS OF INVENTION

The present invention yields a superior effect of being able to provide a high-purity tantalum sputtering target having a uniform and fine structure and enabling plasma stabilization and achievement of superior film evenness (uniformity) by maintaining the high purity of tantalum and adding oxygen as an essential component. Moreover, since the plasma stabilization during sputtering can also be realized during the initial stage of sputtering, the present invention additionally yields the effect of being able to shorten the burn-in time.

### DESCRIPTION OF EMBODIMENTS

High-purity tantalum is used as the raw material of the tantalum (Ta) target in the present invention. An example of this high-purity tantalum is shown in Table 1 (refer to the journal of technical disclosure 2005-502770 entitled "High-purity Tantalum and Sputtering Target composed of High-purity Tantalum" edited by the Japan Institute of Invention and Innovation).

In Table 2, the amount of all impurities excluding gas components is less than 1 mass ppm; that is, 99.999 to 99.9999 mass%, and this kind of high-purity tantalum can be used.

**[Table 1]**

| (Analys is Value) | | | | | | | |
|---|---|---|---|---|---|---|---|
| Element | Concentration [ppm wt] | Element | Concentration [ppm wt] | Element | Concentration [ppm wt] | Element | Concentration [ppm wt] |
| Li | <0.001 | Co | <0.001 | Cd | <0.01 | Tm | <0.005 |
| Be | <0.001 | Ni | <0.005 | In | <0.005 | Yb | <0.005 |
| B | <0.005 | Cu | <0.01 - 0.20 | Sn | <0.05 | Lu | <0.005 |
| F | <0.05 | Zn | <0.01 | Sb | <0.01 | Hf | <0.01 |
| Na | <0.005 | Ga | <0.01 | Te | <0.01 | Ta | Matrix |
| Mg | <0.005 | Ge | <0.01 | I | <0.01 | W | <0.05 - 0.27 |
| Al | <0.005 | As | <0.005 | Cs | <0.005 | Re | <0.01 |
| Si | <0.001 | Se | <0.01 | Ba | <0.005 | Os | <0.005 |
| P | <0.005 | Br | <0.01 | La | <0.005 | Ir | <0.01 |
| s | <0.005 | Rb | <0.005 | Ce | <0.005 | Pt | <0.05 |
| Cl | <0.01 | Sr | <0.005 | Pr | <0.005 | Au | <0.1 |
| K | <0.01 | Y | <0.001 | Nd | <0.005 | Hg | <0.05 |
| Ca | <0.01 | Zr | <0.01 | Sm | <0.005 | Tl | <0.005 |
| Sc | <0.001 | Nb | 0.1 - 0.46 | Eu | <0.005 | Pb | <0.005 |
| Ti | <0.001 | Mo | 0.05 - 0.20 | Gd | <0.005 | Bi | <0.005 |
| V | <0.001 | Ru | <0.01 | Tb | <0.005 | Th | <0.0001 |
| Cr | <0.001 | Rh | <0.005 | Dy | <0.005 | U | <0.0001 |
| Mn | <0.001 | Pd | <0.005 | Ho | <0.005 | | |
| Fe | <0.005 | Ag | <0.005 | Er | <0.005 | | |

The sputtering target of the present invention is ordinarily produced with the following process.

To exemplify a specific example tantalum, for instance, high-purity tantalum of 4N (99.99% or higher), is used, and appropriate amount of oxygen (O) is added thereto to prepare a target raw material. The purity thereof is increased by melting and refining the target raw materail via electron beam melting or the like, and this is cast to prepare an ingot or a biller. Needless to say, the high-purity tantalum of 99.999 to 99.9999 mass% shown in Table 2 may be used as substitute for the above. Subsequently, this ingot or billet is subject to a series of processing steps including annealing-forging, rolling, annealing (heat treatment), finish processing and the like.

Specifically, for instance, a target material is obtained by subjecting the foregoing ingot to: extend forging - (first) annealing at a temperature between 1373 K and 1673 K - (first) cold forging - (second) recrystallization annealing at a temperature between the recrystallization start temperature and 1673 K - (second) cold forging - (third) recrystallization annealing at a temperature between the recrystallization start temperature and 1673 K - (first) cold (hot) rolling - (fourth) recrystallization annealing at a temperature between the recrystallization start temperature and 1373 K - (as needed, second) cold (hot) rolling - (as needed, fifth) recrystallization annealing at a temperature between the recrystallization start temperature and 1373 K - finish processing.

The forging or rolling performed to the ingot or billet will destroy the cast structure, disperse or eliminate the pores and segregations. By further performing annealing thereto, recrystallization will occur, and the densification, refinement and strength of the structure can be improved by repeating the cold forging or cold rolling and the recrystallization annealing. While the recrystallization annealing may only be performed once in the foregoing working process, the structural defects can be reduced as much as possible by repeating such recrystallization annealing twice. Moreover, the cold (hot) rolling and recrystallization annealing performed at a temperature between the recrystallization start temperature and 1373 K may be repeated or may be performed only for one cycle. The final target shape is obtained by subsequently performing finish processing such as machining and polishing.

The tantalum target is ordinarily produced based on the foregoing production process, but this production method is merely an exemplification. Moreover, since the present invention is not an invention of the production process, the target can also be produced based on other processes as a matter of course, and this invention covers all of these targets.

A material having a purity level of 6N is often used to leverage the characteristics of the tantalum target, but there was always a problem in that the crystal grains of the target would easily become coarse.

The present inventors discovered that, in the production of such a 6N-level target, the crystal grain size was locally fine at the portion where oxygen, of which content is approximately 20 mass ppm under normal circumstances, had segregated incidentally at approximately 50 mass ppm. Accordingly, as a result of obtaining the hint that the addition of oxygen may be effective for achieving a finer tantalum target, the present inventors found the opportunity that led to this invention.

Specifically, what is important with the tantalum sputtering target of this invention is that oxygen is contained as an essential component at 30 mass ppm or more and 100 mass ppm or less in tantalum having a purity of 99.998% or higher excluding oxygen and gas components.

In the tantalum sputtering target of the present invention, oxygen exists as a solid solution (interstitial solid solution). 30 mass ppm as the lower limit of oxygen is a numerical value for exhibiting the foregoing effect, and 100 mass ppm as the upper limit of oxygen is the upper limit for maintaining the effect of the present invention. If the oxygen content exceeds this upper limit, segregation of oxygen will occur, recrystallization of oxygen will be partially incomplete, and the burn-in time will consequently be prolonged. Thus, 100 mass ppm set as the upper limit of oxygen.

The inclusion of oxygen in tantalum forms a uniform and fine structure of the target, thereby stabilizes the plasma, and improves the evenness (uniformity) of the sputtered film. Moreover, since the plasma stabilization during sputtering can also be realized during the initial stage of sputtering, the burn-in time can be shortened.

In the foregoing case, tantalum needs to be of high purity; that is, 99.998% or higher. Here, gas components with a small atomic radius such as oxygen, hydrogen, carbon, and nitrogen can be excluded. Generally speaking, it is difficult to eliminate gas components unless a special method is employed, and difficult to eliminate these during the refining in the standard production process. Thus, gas components are excluded from the purity of tantalum of the present invention.

As described above, oxygen realizes the uniform and fine structure of tantalum, but the inclusion of other metal components, half metals (metalloids), oxides, nitrides, carbides and other ceramics is harmful, and cannot be tolerated. This is because these impurity elements are considered to inhibit the effect of oxygen. In addition, unlike in the case of oxygen, it is difficult to achieve a uniform crystal grain size of the tantalum target, and these impurities do not contribute to the stabilization of the sputtering characteristics.

Preferably, the tantalum sputtering target of the present invention contains 40 mass ppm or more and 100 mass ppm or less of oxygen as an essential component, and has a purity of 99.998% or higher excluding oxygen and gas components.

Further preferably, the tantalum sputtering target of the present invention contains 40 mass ppm or more and 70 mass ppm or less of oxygen as an essential component, and has a purity of 99.998% or higher excluding oxygen and gas components.

As examples of metal impurities other than gas components, there are, for example, Mg, Al, Ca, Ti, Cr, Mn, Fe, Ni, Cu, Nb, Mo, Sn, W, and U, and the amount of respective elements is desirably 1 ppm or less.

With the tantalum sputtering target of the present invention, preferably, variation in the oxygen content in the target is ±20% or less.

So as long as the inclusion of an appropriate amount of oxygen yields the function (property) of forming the uniform and fine structure of the tantalum sputtering target, the uniform dispersion of oxygen will contribute even more to the uniform and fine structure of the target.

Needless to say, it is easy to achieve the above with a standard production process, but it is necessary to take note of causing the variation in the oxygen content in the target to be ±20% or less, and to have a clear intent to achieve the same.

The variation in the oxygen content in the target is measured; for example, in the case of a discoid target, by taking three points (center point, 1/2 point of the radius, and point in the outer periphery or its vicinity) on eight equal lines drawn from the center of the disk, and analyzing the oxygen content at a total of 17 points {16 points + center point (since the center point is common, it is counted as one point)}.

Subsequently, the variation is calculated at the respective points based on the formula of {(maximum value - minimum value)/(maximum value + minimum value)} × 100.

With the tantalum sputtering target of the present invention, more preferably, the average crystal grain size is 120 µm or less. The crystal grain size can be refined by the addition of an appropriate amount of oxygen and a normal production process, but it is necessary to take note of causing the average crystal grain size to be 120 µm or less, and to have a clear intent to achieve the same.

The variation in the crystal grain size is ±20% or less.

The variation in the average crystal grain size is measured; for example, in the case of a discoid target, by taking three points (center point, 1/2 point of the radius, and point in the outer periphery or its vicinity) on eight equal lines drawn from the center of the disk, and measuring the crystal grain size of oxide at a total of 17 points {16 points + center point (since the center point is common, it is counted as one point)}. Subsequently, the variation in the crystal grain size is calculated at the respective points based on the formula of {(maximum value - minimum value)/(maximum value + minimum value)} × 100.

This kind of target structure enables plasma stabilization and achievement of superior evenness (uniformity) of the film. Moreover, since the plasma stabilization during sputtering can also be realized during the initial stage of sputtering, the present invention additionally yields the effect of being able to shorten the burn-in time.

### [Examples]

The present invention is now explained in detail with reference to the Examples. These Examples are merely illustrative, and the present invention shall in no way be limited thereby. In other words, the present invention covers the other modes and modifications included in the technical concept of this invention.

### (Example 1)

A raw material obtained by adding oxygen in an amount corresponding to 30 mass ppm to tantalum having a purity of 99.998% was subject to electron beam melting, and this was cast to prepare an ingot having a thickness of 200 mm and a diameter of 200 mm *φ*. The crystal grain size in this case was approximately 50 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 200 µm was obtained. This corresponds to "ingot is subject to: extend forging - (first) annealing at a temperature between 1373 K and 1673 K" described in paragraph [0015] above. The same may be applied to the following Examples and Comparative Examples.

This material was subject to extend forging and upset forging at room temperature once again, and recrystallization annealing was performed thereto again at a temperature of 1400 to 1500 K. This corresponds to "(first) cold forging - (second) recrystallization annealing at a temperature between the recrystallization start temperature and 1673 K" described in paragraph [0015] above. The same may be applied to the following Examples and Comparative Examples.

The foregoing forging and heat treatment processes were repeated once again. This corresponds to "(second) cold forging - (third) recrystallization annealing at a temperature between the recrystallization start temperature and 1673 K" described in paragraph [0015] above. The same may be applied to the following Examples and Comparative Examples.

Consequently, a material having a thickness of 120 mm, a diameter of 130 mm*φ*, and a structure in which the average crystal grain size is 100 µm was obtained.

Subsequently, this was subject to cold rolling and recrystallization annealing at a temperature of 1173 K (this corresponds to "(first) cold (hot) rolling - (fourth) recrystallization annealing at a temperature between the recrystallization start temperature and 1373 K" described in paragraph [0015] described above; and the same may be applied to the following Examples and Comparative Examples), and further subject to finish processing so as to obtain a target material having a thickness of 10 mm and a diameter of 450 mm*φ*.

The halfway and last cold working and recrystallization annealing were adjusted to achieve the following average crystal grain size and variation in the crystal grain size. While the average crystal grain size and variation will also change depending on the additive amount of oxygen, the foregoing adjustment was possible in this Example.

The average crystal grain size of the target was 85 µm, and the variation in the crystal grain size was ±17%. Moreover, the variation in the oxygen content was ±15%. The results are shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are shown in Table 2. As evident from Table 2, the fluctuation of the resistance distribution in the sheet is small (2.4 to 3.1%) from the initial stage to the end stage of sputtering in this Example; that is, the fluctuation of the film thickness distribution is small.

The electrical energy required until the initial stabilization of sputtering was also measured and showed 85 kWh, and the required electrical energy decreased considerably in comparison to the Comparative Examples described later. The results are also shown in Table 2. Accordingly, in addition to being able to reduce the electrical energy required until the initial stabilization (being able to shorten the burn-in time), the evenness (uniformity) of the film was favorable, and it was possible to improve the quality of the sputter deposition.

**[Table 2]**

| | ○ (massppm) | Variation in ○ content | Average crystal grain size (µm) | Variation in crystal grain size | Distribution of sheet resistance | Electrical energy required until initial stabilization | Film uniformity |
|---|---|---|---|---|---|---|---|
| Example 1 | 30 | ±15% | 85 | ±17% | 2.4 ∼ 3.1% | 85kwh | Favorable |
| Example 2 | 50 | ±14% | 70 | ±16% | 2.1 ∼ 2.6% | 75kwh | Favorable |
| Example 3 | 70 | ±18% | 50 | ±12% | 1.5 ∼ 1.8% | 60kwh | Favorable |
| Example 4 | 100 | ±16% | 30 | ±7% | 2.2 ∼ 3.5% | 90kwh | Favorable |
| Comprative Example 1 | 20 | ±15% | 130 | ±35% | 3.7 ∼ 5.8% | 180kwh | Inferior |
| Comprative Example 2 | 150 | ±60% | 15 Unrecrystallized | ±50% | 4.8 ∼ 7.2% | 300kwh | Inferior |

### (Example 2)

A raw material obtained by adding oxygen in an amount corresponding to 50 mass ppm to tantalum having a purity of 99.998% was subject to electron beam metling, and this was cast to prepare an ingot having a thickness of 200 mm and a diameter of 200 mm *φ*. The crystal grain size in this case was approximately 45 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 200 µm was obtained.

This material was subject to extend forging and upset forging at room temperature once again, and recrystallization annealing was performed thereto again at a temperature of 1400 to 1500 K.

The foregoing forging and heat treatment processes were repeated once again, and a material having a thickness of 120 mm, a diameter of 130 mm*φ*, and a structure in which the average crystal grain size is 90 µm was obtained.

Subsequently, this was subject to cold rolling and recrystallization annealing at a temperature of 1173 K, and further subject to finish processing so as to obtain a target material having a thickness of 10 mm and a diameter of 450 mm*φ*.

The halfway and last cold working and recrystallization annealing were adjusted to achieve the following average crystal grain size and variation in the crystal grain size. While the average crystal grain size and variation will also change depending on the additive amount of oxygen, the foregoing adjustment was possible in this Example.

The average crystal grain size of the target was 70 µm, and the variation in the crystal grain size was ±16%. Moreover, the variation in the oxygen content was ±14%. The results are shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are shown in Table 2. As evident from Table 2, the fluctuation of the resistance distribution in the sheet is small (2.1 to 2.6%) from the initial stage to the end stage of sputtering in this Example; that is, the fluctuation of the film thickness distribution is small.

The electrical energy required until the initial stabilization of sputtering was also measured and showed 75 kWh, and the required electrical energy decreased. The results are also shown in Table 2. Accordingly, in addition to being able to shorten the burn-in time, the evenness (uniformity) of the film was favorable, and it was possible to improve the quality of the sputter deposition.

### (Example 3)

A raw material obtained by adding oxygen in an amount corresponding to 70 mass ppm to tantalum having a purity of 99.998% was subject to electron beam melting, and this was cast to prepare an ingot having a thickness of 200 mm and a diameter of 200 mm*φ*. The crystal grain size in this case was approximately 40 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 200 µm was obtained.

This material was subject to extend forging and upset forging at room temperature once again, and recrystallization annealing was performed thereto again at a temperature of 1400 to 1500 K.

The foregoing forging and heat treatment processes were repeated once again, and a material having a thickness of 120 mm, a diameter of 130 mm*φ*, and a structure in which the average crystal grain size is 80 µm was obtained.

Subsequently, this was subject to cold rolling and recrystallization annealing at a temperature of 1173 K, and further subject to finish processing so as to obtain a target material having a thickness of 10 mm and a diameter of 450 mm*φ*.

The halfway and last cold working and recrystallization annealing were adjusted to achieve the following average crystal grain size and variation in the crystal grain size. While the average crystal grain size and variation will also change depending on the additive amount of oxygen, the foregoing adjustment was possible in this Example.

The average crystal grain size of the target was 50 µm, and the variation in the crystal grain size was ±12%. Moreover, the variation in the oxygen content was ±18%. The results are shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are shown in Table 2. As evident from Table 2, the fluctuation of the resistance distribution in the sheet is small (1.5 to 1.8%) from the initial stage to the end stage of sputtering in this Example; that is, the fluctuation of the film thickness distribution is small.

The electrical energy required until the initial stabilization of sputtering was also measured and showed 60 kWh, and the required electrical energy decreased. The results are also shown in Table 2. Accordingly, in addition to being able to shorten the burn-in time, the evenness (uniformity) of the film was favorable, and it was possible to improve the quality of the sputter deposition.

### (Example 4)

A raw material obtained by adding oxygen in an amount corresponding to 100 mass ppm to tantalum having a purity of 99.998% was subject to electron beam melting, and this was cast to prepare an ingot having a thickness of 200 mm and a diameter of 200 mm*φ*. The crystal grain size in this case was approximately 35 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 200 µm was obtained.

This material was subject to extend forging and upset forging at room temperature once again, and recrystallization annealing was performed thereto again at a temperature of 1400 to 1500 K.

The foregoing forging and heat treatment processes were repeated once again, and a material having a thickness of 120 mm, a diameter of 130 mm*φ*, and a structure in which the average crystal grain size is 70 µm was obtained.

Subsequently, this was subject to cold rolling and recrystallization annealing at a temperature of 1173 K, and further subject to finish processing so as to obtain a target material having a thickness of 10 mm and a diameter of 450 mm *φ*.

The halfway and last cold working and recrystallization annealing were adjusted to achieve the following average crystal grain size and variation in the crystal grain size. While the average crystal grain size and variation will also change depending on the additive amount of oxygen, the foregoing adjustment was possible in this Example.

The average crystal grain size of the target was 30 µm, and the variation in the crystal grain size was ±7%. Moreover, the variation in the oxygen content was ±16%. The results are shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are shown in Table 2. As evident from Table 2, the fluctuation of the resistance distribution in the sheet is small (2.2 to 3.5%) from the initial stage to the end stage of sputtering in this Example; that is, the fluctuation of the film thickness distribution is small.

The electrical energy required until the initial stabilization of sputtering was also measured and showed 90 kWh, and the required electrical energy decreased. The results are also shown in Table 2. Accordingly, in addition to being able to shorten the burn-in time, the evenness (uniformity) of the film was favorable, and it was possible to improve the quality of the sputter deposition.

### (Comparative Example 1)

A raw material obtained by adding oxygen in an amount corresponding to 20 mass ppm to tantalum having a purity of 99.995% was subject to electron beam melting, and this was cast to prepare an ingot having a thickness of 200 mm and a diameter of 200 mm *φ.* The crystal grain size in this case was approximately 60 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 200 µm was obtained.

This material was subject to extend forging and upset forging at room temperature once again, and recrystallization annealing was performed thereto again at a temperature of 1400 to 1500 K.

As a result of repeating forging and heat treatment once again, a material having a thickness of 120 mm, a diameter of 130 mm*φ*, and a structure in which the average crystal grain size is 100 µm was obtained.

Subsequently, this was subject to cold rolling and recrystallization annealing at a temperature of 1173 K, and further subject to finish processing so as to obtain a target material having a thickness of 10 mm and a diameter of 450 mm*φ*.

The halfway and last cold working and recrystallization annealing were adjusted to achieve an appropriate average crystal grain size and variation in the crystal grain size, but the foregoing adjustment of the crystal grain size was not possible in this Comparative Example, and resulted in that the average crystal grain size of the target was 130 µm and variation in the crystal grain size was ±35%. In addition, variation in the oxygen content was ±15%. The results are similarly shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are similarly shown in Table 2. As evident from Table 2, the fluctuation of the resistance distribution in the sheet is large (3.7 to 5.8%) from the initial stage to the end stage of sputtering in this Comparative Example; that is, the fluctuation of the film thickness distribution is large.

The electrical energy required until the initial stabilization of sputtering was also measured and showed 180 kWh, and the required electrical energy increased. The results are also shown in Table 2. Accordingly, it was not possible to shorten the burn-in time, the evenness (uniformity) of the film was inferior, and it was not possible to improve the quality of the sputter deposition.

Similar testing was performed for a case of adding oxygen in an amount of 20 mass ppm to tantalum having a purity of 99.999%, but the same tendency as this Comparative Example 1 was observed. It was obvious that this also affected the tendency regardless of the purity of tantalum.

### (Comparative Example 2)

A raw material obtained by adding oxygen in an amount corresponding to 150 mass ppm to tantalum having a purity of 99.999% was subject to electron beam melting, and this was cast to prepare an ingot having a thickness of 200 mm and a diameter of 200 mm *φ*. The crystal grain size in this case was approximately 20 mm.

After performing extend forging to this ingot or billet at room temperature, this was subject to recrystallization annealing at a temperature of 1500 K. As a result, a material having a thickness of 120 mm, a diameter of 130 mm*φ*, and a structure in which the average crystal grain size is 190 µm was obtained.

This material was subject to extend forging and upset forging at room temperature once again, and recrystallization annealing was performed thereto again at a temperature of 1400 to 1500 K.

As a result of repeating forging and heat treatment once again, a material having a thickness of 120 mm, a diameter of 130 mm*φ*, and a structure in which the average crystal grain size is 60 µm was obtained.

Subsequently, this was subject to cold rolling and recrystallization annealing at a temperature of 1173 K, and further subject to finish processing so as to obtain a target material having a thickness of 10 mm and a diameter of 450 mm *φ*.

The halfway and last cold working and recrystallization annealing were adjusted to achieve an appropriate average crystal grain size and variation in the crystal grain size, but the foregoing adjustment was not possible in this Comparative Example, and resulted in that, while the average crystal grain size of the target was 15 µm, unrecrystallized grains existed, and therefore variation in the crystal grain size was large at ±50%. In addition, variation in the oxygen content was ±60%. The results are similarly shown in Table 2.

Since the sheet resistance depends on the film thickness, the distribution of the sheet resistance in the wafer (12 inches) was measured to confirm the distribution condition of the film thickness. Specifically, the sheet resistance was measured at 49 points on the wafer to calculate the standard deviation (σ) thereof.

The results are similarly shown in Table 2. As evident from Table 2, the fluctuation of the resistance distribution in the sheet is large (4.8 to 7.2%) from the initial stage to the end stage of sputtering in this Comparative Example; that is, the fluctuation of the film thickness distribution is large.

The electrical energy required until the initial stabilization of sputtering was also measured and showed 300 kWh, and the required electrical energy increased. The results are also shown in Table 2. Accordingly, it was not possible to shorten the burn-in time, the evenness (uniformity) of the film was inferior, and it was not possible to improve the quality of the sputter deposition.

When the amount of oxygen added to tantalum having a purity of 99.998% exceeded 100 mass ppm, the crystal grain size coarsened and the variation increased rapidly, and variation in the oxygen content became prominent. This is considered to be a result of the segregation of oxygen, and it was discovered that the addition of excessive oxygen is undesirable.

### INDUSTRIAL APPLICABILITY

The present invention yields a superior effect of being able to provide a high-purity tantalum sputtering target having a uniform and fine structure and enabling plasma stabilization and achievement of superior film evenness (uniformity) by containing 30 mass ppm or more and 100 mass ppm or less of oxygen as an essential component, and by having a purity of 99.998% or higher excluding oxygen and gas components. Moreover, since the plasma stabilization during sputtering can also be realized during the initial stage of sputtering, the present invention additionally yields the effect of being able to shorten the burn-in time. Thus, the target of the present invention is useful in the electronics field, particularly as a target suitable for forming films of complex shapes, forming circuits or forming barrier films.

## Claims

1. A tantalum sputtering target, comprising 30 mass ppm or more and 100 mass ppm or less of oxygen as an essential component, wherein the purity of the tantalum sputtering target excluding oxygen and gas components is 99.998 mass % or higher,
**characterized by** the tantalum sputtering target having a recrystallized structure wherein the average crystal grain size of the recrystallized structure is 120 µm or less; and
variation in the crystal grain size within the target as determined by the method according to the description is ±20% or less.

2. The tantalum sputtering target of claim 1, wherein the content of oxygen is 40 mass ppm or more.

3. A tantalum sputtering target of claim 2, wherein the content of oxygen is 70 mass ppm or less.

4. The tantalum sputtering target according to any one of claims 1 to 3, wherein the variation in the oxygen content in the target as determined by the method according to the description is ±20% or less.

## Patentansprüche

1. Tantal-Sputtertarget, das 30 Masse-ppm oder mehr und 100 Masse-ppm oder weniger Sauerstoff als wesentliche Komponente umfasst, wobei die Reinheit des Tantal-Sputtertargets ohne Sauerstoff- und Gaskomponenten 99,998 Masse-% oder mehr beträgt,
**dadurch gekennzeichnet, dass** das Tantal-Sputtertarget eine rekristallisierte Struktur aufweist,
wobei die durchschnittliche Kristallkorngröße der rekristallisierten Struktur 120 µm oder weniger beträgt; und
wobei die Variation der Kristallkorngröße innerhalb des Targets, wie durch das Verfahren gemäß der Beschreibung bestimmt, ±20 % oder weniger beträgt.

2. Tantal-Sputtertarget nach Anspruch 1, wobei der Sauerstoffgehalt 40 Masse-ppm oder mehr beträgt.

3. Tantal-Sputtertarget nach Anspruch 2, wobei der Sauerstoffgehalt 70 Masse-ppm oder weniger beträgt.

4. Tantal-Sputtertarget nach einem der Ansprüche 1 bis 3, wobei die Schwankung des Sauerstoffgehalts im Target, wie durch das Verfahren gemäß der Beschreibung bestimmt, ±20 % oder weniger beträgt.

## Revendications

1. Cible de pulvérisation cathodique de tantale, comprenant 30 ppm en masse ou plus et 100 ppm en masse ou moins d'oxygène en tant que composant essentiel, dans laquelle la pureté de la cible de pulvérisation cathodique de tantale à l'exclusion de l'oxygène et des composants gazeux est de 99,998 % en masse ou plus, **caractérisée en ce que**
la cible de pulvérisation cathodique de tantale a une structure recristallisée dans laquelle la taille de grain cristallin moyenne de la structure recristallisée est de 120 µm ou moins ; et
la variation de la taille de grain cristallin dans la cible, telle que déterminée par le procédé conforme à la description, est de ± 20 % ou moins.

2. Cible de pulvérisation cathodique de tantale selon la revendication 1, dans laquelle la teneur en oxygène est de 40 ppm en masse ou plus.

3. Cible de pulvérisation cathodique de tantale selon la revendication 2, dans laquelle la teneur en oxygène est de 70 ppm en masse ou moins.

4. Cible de pulvérisation cathodique de tantale selon l'une quelconque des revendications 1 à 3, dans laquelle la variation de la teneur en oxygène de la cible, telle que déterminée par le procédé conforme à la description, est de ± 20 % ou moins.
